# EUROPEAN PATENT SPECIFICATION

(11) **EP 2 897 276 B1**
(45) Date of publication and mention of the grant of the patent: **15.05.2019**
(21) Application number: 15150600.3
(22) Date of filing: 09.01.2015
(51) Int. Cl.: H05K 7/14, H05K 1/18, H05K 1/11, H01R 12/55, H02M 7/5387

(54) **Semiconductor device**
Halbleiterbauelement
Dispositif semi-conducteur

(30) Priority: 17.01.2014 JP 2014006823; 12.11.2014 JP 2014230043
(43) Date of publication of application: 22.07.2015
(73) Proprietor: KABUSHIKI KAISHA TOYOTA JIDOSHOKKI, Kariya-shi, Aichi-ken, 448-8671 (JP)
(72) Inventor: Kontani, Kazuyoshi, Kariya-shi, Aichi-ken 448-8671 (JP); Ito, Kenichiro, Kariya-shi, Aichi-ken 448-8671 (JP)
(74) Representative: Winter, Brandl, Fürniss, Hübner, Röss, Kaiser, Polte - Partnerschaft mbB

(56) References cited:
- EP-A1- 1 677 389
- EP-A2- 0 924 845
- EP-A2- 2 475 236
- US-A1- 2009 130 869

## Description

### BACKGROUND OF THE INVENTION

### Field of the Invention

The present invention relates to a semiconductor device.

### Related Background Art

There have been known a semiconductor device including a main circuit substrate which is provided with a plurality of semiconductor elements and forms a main circuit, a capacitor substrate which is provided with a plurality of capacitors, and a control substrate which is provided with a control circuit, these three substrates being placed and stacked so as to be opposed to each other (refer to Japanese Registered Utility Model Publication No. 3173512, for example).

Document EP1677389A1 discloses a power terminal for electrical connection of an electric cable to a circuit board comprising a main body having a central longitudinal axis and means for attaching a cable to the main body. An eccentric body integral with the main body and having a through hole is arranged to receive a screw. A space is provided at the bottom of the power terminal adjacent to the eccentric body. This configuration provides a means for securing the terminal while also providing for mounting of a current measuring device, for example.

Document EP2475236A2 discloses a power switching circuitry, where an electrically insulating locating member is provided between a heat conductive substrate and a standard circuit board, and comprises a plurality of locating holes shaped to receive the first portion of each of a plurality of electrically conductive members, and to inhibit rotation of the electrically conductive member about the first axis.

### SUMMARY OF THE INVENTION

The semiconductor device described in Japanese Registered Utility Model Publication No. 3173512 has an input terminal electrode and an output terminal electrode to which external wirings are connected, the input terminal electrode and the output terminal electrode being each secured to the main circuit substrate through screws and the like, at plural positions, so that the substrate has a larger area for mounting the respective terminal electrodes thereon. In order to reduce the size of the semiconductor device, it is necessary to reduce the area for mounting the respective terminal electrodes therein. By reducing the number of the positions at which each terminal electrode is secured to the substrate, such as, for example, by making this number be one, it is possible to reduce the area in the substrate for mounting the terminal electrodes thereon. However, in the case where the number of positions at which each terminal electrode is secured to the substrate is one, when the external wiring is connected and secured to the terminal electrode, the terminal electrode may be rotated on the substrate about the position at which it is secured thereto, due to forces exerted on the terminal electrode (such as forces for fastening a bolt thereto).

In order to prevent such rotations of the terminal electrodes along with operations for connecting the external wirings thereto, utilization of the following structure may be possibly contrived. For example, in a case where the number of positions at which a terminal electrode is secured to the substrate is only one, the terminal electrode is provide with a protruding portion protruding toward the substrate, at a position different from the position at which it is secured to the substrate. The substrate is provided with a positioning hole through which the protruding portion provided in the terminal electrode can penetrate. The protruding portion is inserted through the positioning hole, so that the protruding portion is engaged with the positioning hole, which prevents rotations of the terminal electrode.

However, with the structure having the terminal electrodes provided with the protruding portions and the substrate provided with the positioning holes, it is hard to mount electronic components on the substrate, in areas in which the positioning holes are formed and in areas around these areas. This makes it impossible to improve the electronic-component mountability of the substrate, which may cause a disadvantage to reduction in size of the semiconductor device. The substrate is provided with terminal electrode connection portions which are electrically connected to the terminal electrodes, and wirings which are connected to these terminal electrode connection portions. If the positioning holes are formed around the terminal electrode connection portions in the substrate, this may impose constraints on the design of the wirings, thereby inducing new problems. For example, due to shortage of wiring widths or due to congestions of plural wirings, thermal disadvantages may be caused to the semiconductor device.

It is an object of various aspects of the present invention to provide an inverter device which is capable of suppressing rotations of terminal electrodes on a substrate during connection of external wirings thereto, while enabling reduction in size of the inverter device.

In an aspect of the present invention, an inverter device includes a terminal electrode connected to a circuit substrate having a plurality of semiconductor elements mounted thereon, and a terminal electrode placement member configured to place the terminal electrode therein. The terminal electrode includes a substrate-fixed portion secured to the circuit substrate through a fastening member, and an external wiring connection portion to which an external wiring is connected. The substrate-fixed portion and the external wiring connection portion are eccentrically located when viewed from a direction orthogonal to the circuit substrate. The terminal electrode placement member includes a plurality of securing portions which are secured to the circuit substrate, and a rotation suppressing portion configured to suppress a rotation of the terminal electrode, and the rotation suppressing portion is provided with a penetration hole for penetrating the substrate-fixed portion therethrough. The rotation suppressing portion includes a pair of walls which are opposed to each other and also are positioned in opposite sides beside the terminal electrode which is inserted into the penetration hole at the substrate-fixed portion. The terminal electrode comes into contact with these walls for suppressing the rotation of the terminal electrode.

In the aforementioned aspect, the rotation suppressing portion in the terminal electrode placement member includes the pair of walls which are opposed to each other and also are positioned in the opposite sides beside the terminal electrode which is inserted, at the substrate-fixed portion, into the penetration hole provided in this rotation suppressing portion. The walls in the rotation suppressing portion are such that the terminal electrode comes into contact with these walls, which suppresses the rotation of the terminal electrode. Therefore, for example, even if a force for rotating the external wiring connection portion about the substrate-fixed portion is exerted on the terminal electrode, the aforementioned walls inhibit the terminal electrode from being rotated. The terminal electrode is placed in the terminal electrode placement member having the plurality of securing portions secured to the circuit substrate, so that the terminal electrode is mounted on the circuit substrate. This eliminates the necessity of forming a positioning hole in the circuit substrate. Accordingly, for example, it is possible to increase the density of electronic components mounted on the substrate, which eliminates the necessity of increasing the size of the circuit substrate. This enables reduction in size of the inveter device.

In the aforementioned aspect, the inverter device further includes a capacitor substrate having a plurality of capacitors mounted thereon, the capacitor substrate being placed oppositely to the circuit substrate. The terminal electrode placement member is placed on a surface of the capacitor substrate which is opposite from a surface of the capacitor substrate which is opposed to the circuit substrate.

In the aforementioned aspect, the pair of the walls may be configured to sandwich the terminal electrode. In this case, the terminal electrode is held by the rotation suppressing portion in the terminal electrode placement member, which certainly suppresses the rotation of the terminal electrode with the pair of the walls.

In the aforementioned aspect, the substrate-fixed portion may be positioned closer to the circuit substrate than the external wiring connection portion, and the pair of the walls may sandwich the terminal
electrode, from an end portion of the substrate-fixed portion which is farther from the circuit substrate, up to an end portion of the external wiring connection portion which is closer to the circuit substrate. In this case, for example, when the external wiring is mounted thereto, even if a rotational moment is exerted on the terminal electrode, it is possible to suppress rotations of the terminal electrode, more certainly.

In the aforementioned aspect, an interval between the pair of the walls in a direction in which the pair of the wall are opposed to each other may be larger than a width of the terminal electrode in the direction in which the pair of the wall are opposed to each other. In this case, it is possible to easily insert the substrate-fixed portion of the terminal electrode, through the penetration hole provided in the rotation suppressing portion. This makes it easier to place the terminal electrode in the terminal electrode placement member.

In the aforementioned aspect, a plurality of the terminal electrodes may be connected to the circuit substrate, the terminal electrode placement member may include a plurality of the rotation suppressing portions, and the plurality of the rotation suppressing portions may be formed integrally. In this case, the plurality of terminal electrodes are placed in the terminal electrode placement member. This reduces the number of members in the terminal electrode placement member to be used.

In the aforementioned aspect, two rotation suppressing portions adjacent to each other, out of the plurality of the rotation suppressing portions, may be configured to share a wall positioned between these two rotation suppressing portions, out of the pair of walls. In this case, it is possible to realize a structure having the plurality of terminal electrodes which are placed on the substrate in the state where they are arranged substantially in a line, for example.

In the aforementioned aspect, the terminal electrode placement member may have a supporting portion configured to support the external wiring connection portion. In this case, it is possible to place the terminal electrode, more stably.

The present invention will become more fully understood from the detailed description given hereinbelow and the accompanying drawings which are given by way of illustration only, and thus are not to be considered as limiting the present invention.

Further scope of applicability of the present invention will become apparent from the detailed description given hereinafter. However, it should be understood that the detailed description and specific examples, while indicating preferred embodiments of the invention, are given by way of illustration only, since various changes and modifications within the spirit and scope of the invention will become apparent to those skilled in the art from this detailed description.

### BRIEF DESCRIPTION OF THE DRAWINGS

Fig. 1 is an exploded perspective view illustrating an inverter device according to an embodiment of the present invention.
Fig. 2 is a sectional view of the inverter device illustrated in Fig. 1.
Fig. 3 is a circuit diagram of the inverter device illustrated in Fig. 1.
Fig. 4 is a plan view illustrating a structure of components mounted on an upper substrate illustrated in Fig. 1.
Fig. 5 is a perspective view of a secure bracket according to the present embodiment.
Fig. 6 is a side view illustrating a structure for securing a connection terminal in a comparative example.
Fig. 7 is a side view illustrating a structure for securing a connection terminal according to the present embodiment.
Fig. 8 is a sectional view of an inverter device in a modification example of the present embodiment.
Fig. 9 is a sectional view of the inverter device in the modification example of the present embodiment.
Fig. 10 is a sectional view of the inverter device in the modification example of the present embodiment.
Fig. 11 is a view illustrating the relationship between the secure bracket and an input terminal.

### DESCRIPTION OF THE PREFERRED EMBODIMENTS

The embodiment of the present invention will be described in detail referring to the attached drawings. In the description, the same component or the component having the same function is denoted with the same reference sign and repeated description thereof will be omitted. Dimensional ratios in each drawing may be different from the actual dimensional ratios.

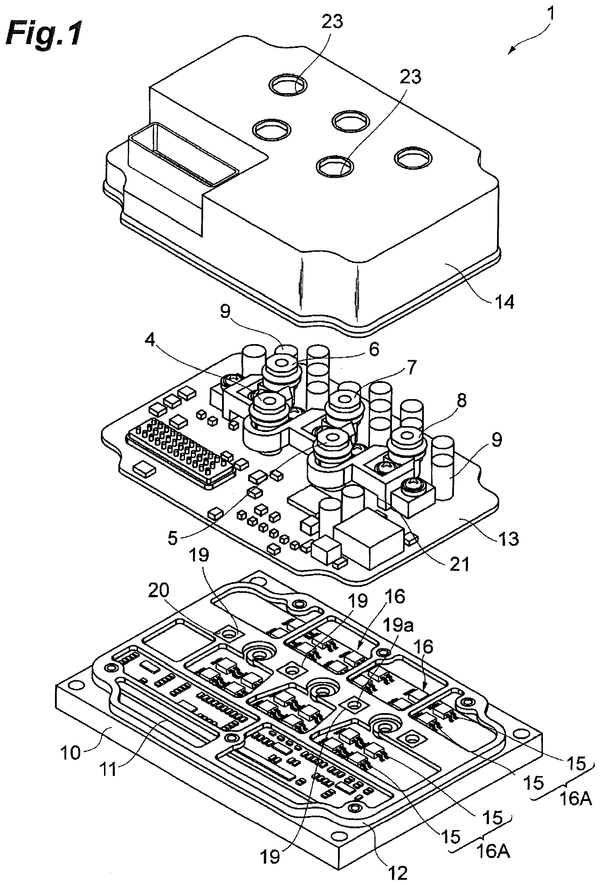

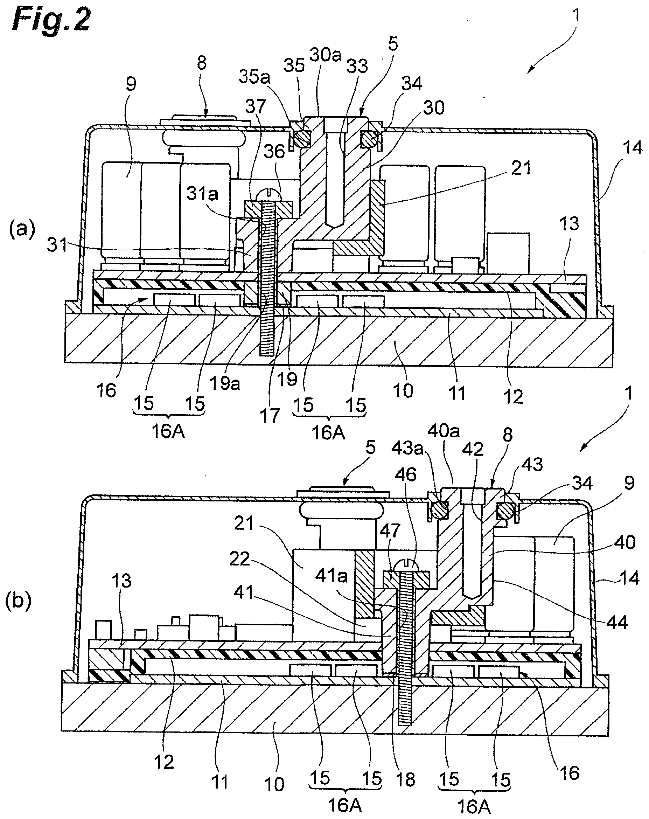

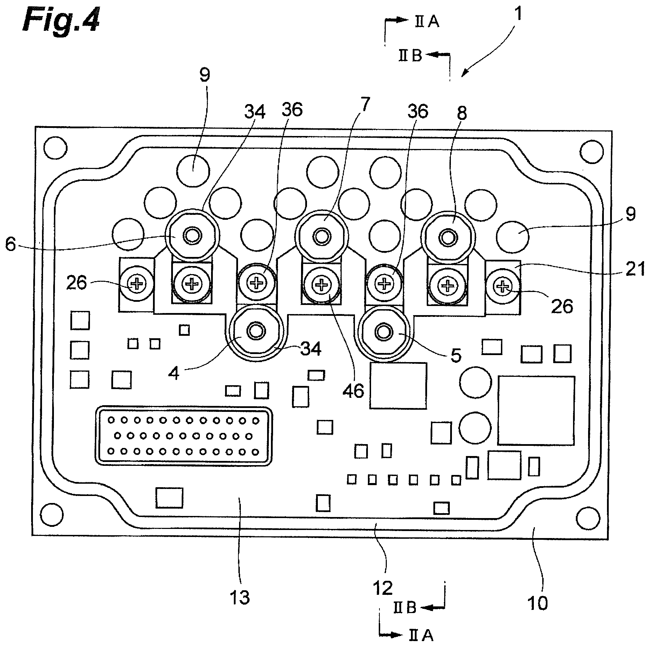

FIG. 1 is an exploded perspective view illustrating an inverter device according to the embodiment. FIG. 2 is sectional views of the inverter device illustrated in FIG. 1. In FIG. 2, (a) is a sectional view taken along the line IIA-IIA in FIG. 4 and (b) is a sectional view taken along the line IIB-IIB in FIG. 4. The inverter device 1 of the embodiment is, for example, a three-phase inverter device for driving a three-phase AC motor.

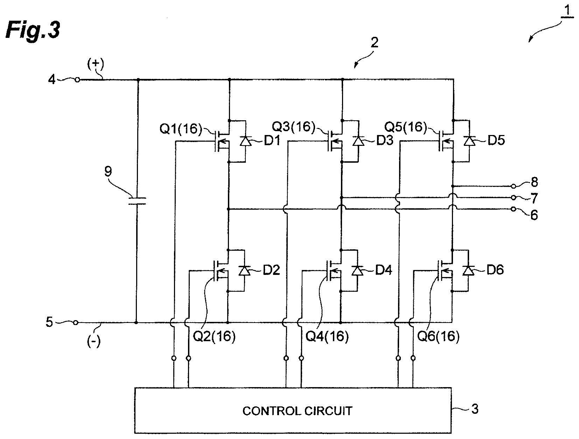

FIG. 3 is a circuit diagram of the inverter device 1. As illustrated in FIG. 3, the inverter device 1 includes a main circuit 2, which is an inverter circuit, a control circuit 3 for controlling the main circuit 2, and a positive electrode terminal 4 and a negative electrode terminal 5, which are terminal electrodes. The positive electrode terminal 4 and the negative electrode terminal 5 are connected to the main circuit 2 which is an internal circuit, and an external power source (not shown) such as batteries. The positive electrode terminal 4 and the negative electrode terminal 5 are input terminals to supply power to the main circuit 2 from the external power source.

The main circuit 2 includes six switching elements Q1 to Q6 connected in a three-phase bridge and flywheel diodes D1 to D6 each of which connected in parallel to each of the switching elements Q1 to Q6. For example, metal oxide semiconductor field effect transistor (MOSFET) is used for the switching elements Q1 to Q6. In FIG. 3, a switching element group 16 (see FIG. 1) including a plurality of switching elements (e.g., four switching elements) 15 connected in parallel is illustrated as a component equivalent to each of switching elements Q1 to Q6. A group including the switching elements Q1, Q3, and Q5 and the flywheel diodes D1, D3, and D5 constitutes an upper arm. A group including the switching elements Q2, Q4, and Q6 and the flywheel diodes D2, D4, and D6 constitutes a lower arm. The switching elements 15 function as semiconductor elements.

The switching elements Q1 and Q2 are connected in series between the positive electrode terminal 4 and the negative electrode terminal 5. A U-phase output terminal 6 which is a terminal electrode is connected to the connecting points of the switching elements Q1 and Q2. The switching elements Q3 and Q4 are connected in series between the positive electrode terminal 4 and the negative electrode terminal 5. A V-phase output terminal 7 which is a terminal electrode is connected to the connecting points of the switching elements Q3 and Q4. The switching elements Q5 and Q6 are connected in series between the positive electrode terminal 4 and the negative electrode terminal 5. A W-phase output terminal 8 which is a terminal electrode is connected to the connecting points of the switching elements Q5 and Q6. The U-phase output terminal 6, the V-phase output terminal 7, and the W-phase output terminal 8 are output terminals for supplying three-phase AC power to an external motor.

A capacitor 9 which is an electronic component constituting the main circuit 2 is connected between the positive electrode terminal 4 and the negative electrode terminal 5. In FIG. 3, a plurality of capacitors 9 connected to the main circuit 2 is illustrated as a single capacitor (see FIGS. 1 and 2).

The control circuit 3 controls switching (ON/OFF) of each of the switching elements Q1 to Q6. The control circuit 3 can be configured as a part of an electronic control unit (ECU). For example, the control circuit 3 switches each of the switching elements Q1 to Q6 as required according to a load condition and a value required from an operator.

Now, referring back to FIGS. 1 and 2. The inverter device 1 includes a lower substrate 11 arranged on a heat sink 10, an upper substrate 13 arranged above the lower substrate 11 with a spacer bracket 12 in between, a case 14 covering the lower substrate 11 and the upper substrate 13, the positive electrode terminal 4 and the negative electrode terminal 5 (hereinafter, may referred to as input terminals 4 and 5), and the U-phase output terminal 6, the V-phase output terminal 7, and the W-phase output terminal 8 (hereinafter, may referred to as output terminals 6 to 8). The lower substrate 11 is, for example, an insulated metal substrate (IMS). The upper substrate 13 is, for example, a printed circuit board. The lower substrate 11 and the upper substrate 13 are screwed on the heat sink 10. The case 14 is also screwed on the heat sink 10.

Electronic components constituting a part of the main circuit 2 are mounted on the lower substrate 11. Specifically, the switching element group 16 including a plurality of switching elements (four switching elements in the embodiment) 15 is mounted on the lower substrate 11. The switching element group 16 is arrayed in six rows along a longitudinal direction of the lower substrate 11. The switching element group 16 forms the switching elements Q1 to Q6. The switching element group 16 in the upper arm and the switching element group 16 in the lower arm are adjoiningly arranged.

The four switching elements 15 constituting the switching element group 16 are connected in parallel as described above, and arranged along a direction perpendicular to the longitudinal direction of the lower substrate 11. The four switching elements 15 are separated in two element groups 16A. That is, the switching element group 16 includes the two element groups 16A. In the embodiment, each element group 16A includes two switching elements 15. Each switching element 15 is mounted on the lower substrate 11. An input electrode pattern 17 and an output electrode pattern 18 are arrayed in the region between the element groups 16A on the lower substrate 11. Each of the input electrode pattern 17 and the output electrode pattern 18 is electrically connected to each switching element 15 via each wiring pattern (not shown).

Electronic components constituting the control circuit 3 are also mounted on the lower substrate 11.

The spacer bracket 12 includes a plurality of electrode accommodating portions (four electrode accommodating portions in the embodiment) 20 which accommodates a rectangular relay electrode 19. The relay electrode 19 has a penetration hole 19a which a terminal securing screw 36 penetrates therethrough. When the spacer bracket 12 is mounted on the lower substrate 11, the relay electrode 19 accommodated in each electrode accommodating portion 20 is arranged in the region between element groups 16A. The relay electrode 19 is electrically connected to the input electrode pattern 17 formed on the lower substrate 11.

As illustrated in Fig. 4, the plurality of capacitors 9, and the components which constitute the control circuit 3 are mounted, on the upper substrate 13. In an area, on the upper substrate 13, between the area in which the capacitors 9 are mounted, and the area in which the components of the control circuit 3 are mounted, the input terminals 4 and 5 and the output terminals 6 to 8 are secured thereto through a secure bracket 21. The upper substrate 13 is placed proximally to the lower substrate 11. Namely, the lower substrate 11 and the upper substrate 13 are placed oppositely to each other with the spacer bracket 12 interposed therebetween. The upper substrate 13 functions as a capacitor substrate having the plurality of capacitors 9 mounted thereon.

On the upper substrate 13, there is provided an electric sensor 22 for detecting the electric currents flowing through the output terminals 7 and 8.

Five holes 23 through which top end surfaces of the input terminals 4 and 5 and the output terminals 6 to 8 are exposed out of the case 14 are formed in the upper portion of the case 14. The inner walls of the case 14 defining each of the holes 23 determine the position of each top end portion of the input terminals 4 and 5 and the output terminals 6 to 8.

The input terminals 4 and 5 have a crank shape (in (a) of Fig. 2, only the input terminal 5 is illustrated). The input terminals 4 and 5 include an external wiring connection portion 30 to which a terminal of an external wiring (not illustrated) is connected, and a substrate-fixed portion 31 which is connected and secured to the lower substrate 11 as a circuit substrate (and a main circuit substrate). The substrate-fixed portion 31 is integrally and eccentrically provided to the external wiring connecting portion 30. Namely, in the present embodiment, the external wiring connecting portion 30 and the substrate-fixed portion 31 are eccentrically located when viewed from a direction orthogonal to the lower substrate 11. Further, the external wiring connecting portion 30 and the substrate-fixed portion 31 are in different locations along in the direction orthogonal to the lower substrate 11. The substrate-fixed portion 31 is located closer to the lower substrate 11 (the upper substrate 13) than the external wiring connection portion 30, when viewed from a direction parallel to the lower substrate 11. The substrate-fixed portion 31 is connected and secured to the lower substrate 11, so that the input terminal 4 or 5 is connected to the lower substrate 11. The input terminals 4 and 5 are mounted to the lower substrate 11, such that the external wiring connection portions 30 are located closer to the area, on the upper substrate 13, in which the components of the control circuit 3 are mounted.

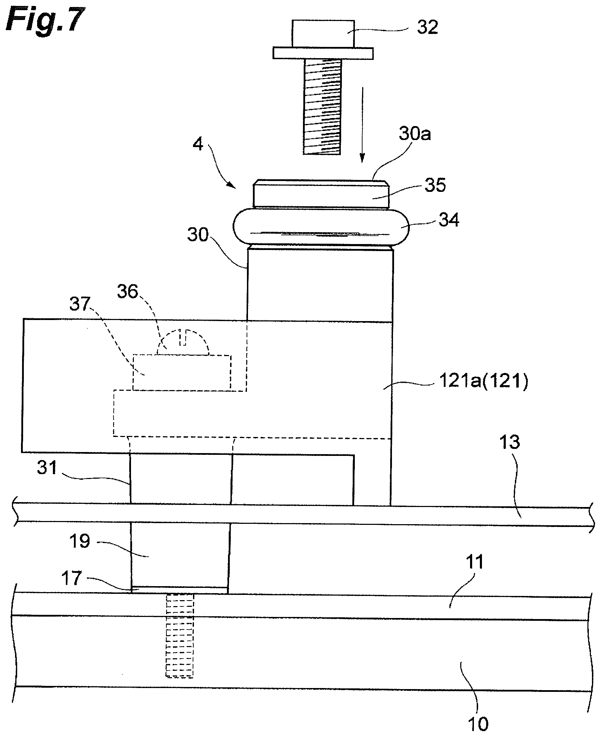

The external wiring connecting portion 30 has a top end surface 30a. The top end surface 30a is an external terminal securing surface to which the external wiring terminal (not shown) is secured with a bolt 32 (see FIG. 7). The top end surface 30a is formed in a substantially polygonal shape (substantially octagonal shape in the embodiment). The hole 23 in the case 14 is formed in a substantially polygonal shape (substantially octagonal shape in the embodiment) corresponding to the shape of the top end surface 30a. A threaded portion 33 configured to engage with the bolt 32 is formed in the external wiring connecting portion 30.

A seal attachment portion 35 is provided in the upper portion of the external wiring connecting portion 30. A seal member 34 is attached to the seal attachment portion 35 to seal the gap between the upper portion of the external wiring connecting portion 30 and the case 14. For example, a rubber O-ring is used as the seal member 34. The seal attachment portion 35 is configured to have an annular groove 35a in which the seal member 34 is fitted.

The substrate-fixed portion 31 is provided with a penetration hole 31a for penetrating a terminal securing screw 36 as a securing part (fastening member) therethrough. The input terminal 4 or 5 is connected and secured to the lower substrate 11 through the terminal securing screw 36. The input terminal 4 or 5 is secured to the lower substrate 11, through processes which will be described later. A lower portion of the external wiring connection portion 30 is placed on the secure bracket 21 and, also, the substrate-fixed portion 31 is placed on an input wiring pattern on the upper surface of the upper substrate 13. At this time, a relay electrode 19 is arranged between both the substrates 11 and 13 so as to electrically connect an input wiring pattern on the back surface of the upper substrate 13 to the input electrode pattern 17 on the lower substrate 11. In this state, the terminal securing screw 36 is inserted into the penetration holes 31a in the substrate-fixed portions 31, with an insulator 37 interposed therebetween. The terminal securing screw 36 is fastened, through a screw effect, to a screw hole formed in the heat sink 10, with the upper substrate 13, the relay electrode 19, and the lower substrate 11 interposed therebetween, so that these plurality of members are integrally secured. Through these processes, the input terminal 4 or 5 is connected and secured to the lower substrate 11. The input wiring pattern on the upper surface of the upper substrate 13 is electrically connected to the input wiring pattern on the back surface of the upper substrate 13.

The output terminals 6 to 8 have a crank shape, similarly to the input terminals 4 and 5 (in (b) of Fig. 2, only the output terminal 8 is illustrated). The output terminals 6 to 8 include an external wiring connection portion 40 to which a terminal of an external wiring (not illustrated) is connected, and a substrate-fixed portion 41 which is secured to the lower substrate 11. The substrate-fixed portion 41 is integrally and eccentrically provided to the external wiring connecting portion 40. Namely, in the present embodiment, the external wiring connection portion 40 and the substrate-fixed portion 41 are eccentrically located when viewed from the direction orthogonal to the lower substrate 11. Further, the external wiring connection portion 40 and the substrate-fixed portion 41 are in different locations along in the direction orthogonal to the lower substrate 11. The substrate-fixed portion 41 is located closer to the lower substrate 11 than the external wiring connection portion 40, when viewed from the direction parallel with the lower substrate 11. The output terminals 6 to 8 are mounted to the lower substrate 11, such that the external wiring connection portions 40 are positioned closer to the area, on the upper substrate 13, in which the capacitors 9 are mounted.

The external wiring connecting portion 40 has a top end surface 40a. The top end surface 40a is an external terminal securing surface to which the external wiring terminal (not shown) is secured with a bolt. Similarly to the top end surface 30a of the external terminal connecting portion 30, the top end surface 40a is formed in a substantially polygonal shape (substantially octagonal shape in the embodiment). A threaded portion 42 configured to engage with the bolt is formed in the external wiring connecting portion 40.

A seal attachment portion 43 is provided in the upper portion of the external wiring connecting portion 40. A seal member 34 is attached to the seal attachment portion 43 to seal the gap between the upper portion of the external wiring connecting portion 40 and the case 14. Similarly to the seal attachment portion 35, the seal attachment portion 43 is configured to have an annular groove 43a in which the seal member 34 is fitted.

The substrate-fixed portion 41 is provided with a penetration hole 41a for penetrating a terminal securing screw 46 as a securing part therethrough. The output terminal 6, 7 or 8 is connected and secured to the lower substrate 11 through the terminal securing screw 46. The output terminal 6, 7 or 8 is secured to the lower substrate 11, through processes which will be described later. A lower portion of the external wiring connection portion 40 is placed on the secure bracket 21 and, also, the substrate-fixed portion 41 is placed on the output electrode pattern 18 on the lower substrate 11 through the penetration holes 41a formed in the upper substrate 13. In this state, the terminal securing screw 46 is inserted into the penetration hole 41a in the substrate-fixed portion 41, with an insulator 47 interposed therebetween. The terminal securing screw 46 is fastened, through a screw effect, to a screw hole formed in the heat sink 10, with the lower substrate 11 interposed therebetween. Through these processes, the output terminal 6, 7 or 8 is connected and secured to the lower substrate 11.

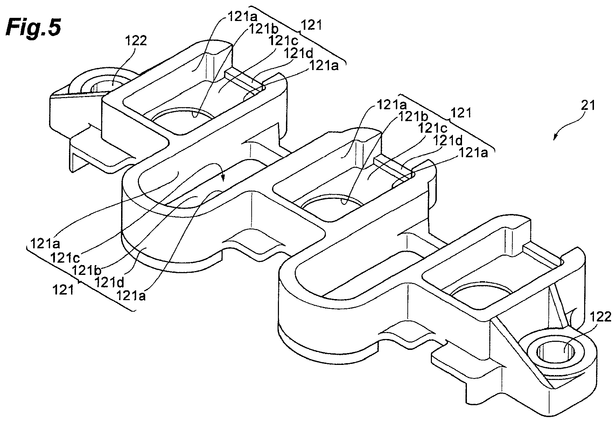

Hereinafter, with reference to Fig. 5, the secure bracket 21 will be described. Fig. 5 is a perspective view of the secure bracket 21 according to the present embodiment.

The secure bracket 21 secures the input terminals 4 and 5 and the output terminals 6 to 8 to the upper substrate 13. The secure bracket 21 includes a plurality of holding portions (in this case, five holding portions) 121, and a plurality of securing portions (in this case, two securing portions) 122. The secure bracket 21 is a member constituted by these holding portions 121 and these securing portions 122 which are integrally formed and, further, the secure bracket 21 is made of a resin. The secure bracket 21 is placed on the surface of the upper substrate 13 which is opposite from the surface thereof opposing the lower substrate 11.

The holding portions 121 have respective terminal mounting areas 121c on which the substrate-fixed portions 31 of the input terminals 4 and 5 and the substrate-fixed portions 41 of the output terminals 6 to 8 are mounted. The holding portions 121 each have a pair of sandwiching walls 121a opposing to each other and are configured to hold a respective one of the input terminals 4 and 5 and the output terminals 6 to 8. The respective holding portions 121 are arranged in substantially the same direction as a direction in which the pairs of the sandwiching walls 121a are opposed to each other. The input terminals 4 and 5 and the output terminals 6 to 8 are held by the respective corresponding holding portions 121, so that the secure bracket 21 functions as a terminal electrode holding member for holding the input terminals 4 and 5 and the output terminals 6 to 8 and, also, the secure bracket 21 functions as a terminal electrode placement member for placing the input terminals 4 and 5 and the output terminals 6 to 8 therein.

The plurality of holding portions 121 are in different locations along in a direction orthogonal to the direction in which the pairs of the sandwiching walls 121a are opposed to each other. Therefore, through the secure bracket 21, the input terminals 4 and 5 are secured to the upper substrate 13, near an area in which the components of the control circuit 3 are mounted thereon. Through the secure bracket 21, the output terminals 6 to 8 are secured to the upper substrate 13, near an area in which the capacitors 9 are mounted thereon.

A penetration hole 121b is formed in the terminal mounting area 121c in each holding portion 121. The terminal mounting area 121c is a supporting portion for supporting the corresponding one of the external wiring connection portions 30 of the input terminals 4 and 5 or the external wiring connection portions 40 of the output terminals 6 to 8. The penetration hole 121b is configured such that the corresponding one of the substrate-fixed portions 31 of the input terminals 4 and 5 or the substrate-fixed portions 41 of the output terminals 6 to 8 is penetrated therethrough. When the input terminals 4 and 5 are secured to the upper substrate 13, the substrate-fixed portions 31 of the input terminals 4 and 5 are inserted through the respective penetration holes 121b. When the output terminals 6 to 8 are secured to the upper substrate 13, the substrate-fixed portions 41 of the output terminals 6 to 8 are inserted through the respective penetration holes 121b. Namely, the pairs of sandwiching walls 121a are positioned in the opposite sides beside the respective terminals 4 to 8 which are inserted into the penetration holes 121b at their substrate-fixed portions 31 and 41. In the present embodiment, the opening shape of the penetration holes 121b through which the input terminals 4 and 5 are inserted is a substantially-rectangular shape. The opening shape of the penetration holes 121b through which the output terminals 6 to 8 are inserted is a substantially-circular shape. The opening shapes of the penetration holes 121b can be changed as appropriate, depending on the cross-sectional shapes of the substrate-fixed portions 31 of the input terminals 4 and 5 or the substrate-fixed portions 41 of the output terminals 6 to 8. Each holding portion 121 is provided with a reinforcement wall 121d between the pair of sandwiching walls 121a.

The sandwiching walls 121a sandwich, therebetween, the opposite side surfaces of the input terminals 4 and 5 and the output terminals 6 to 8, from upper portions of the substrate-fixed portions 31 and 41 to lower portions of the external wiring connection portions 30 and 40. In other words, the sandwiching walls 121a sandwich, therebetween, the input terminals 4 and 5 and the output terminals 6 to 8, from end portions of the substrate-fixed portions 31 and 41 which are farther from the lower substrate 11 up to end portions of the external wiring connection portions 30 and 40 which are closer to the lower substrate 11. The input terminals 4 and 5 and the output terminals 6 to 8 are sandwiched by the sandwiching walls 121a in the holding portions 121. Namely, the sandwiching walls 121a are in contact with the input terminals 4 and 5 and the output terminals 6 to 8. The input terminals 4 and 5 and the output terminals 6 to 8 are sandwiched thereby at their opposite side surfaces, up to the lower portions of the external wiring connection portions 30 and 40, which can suppress the rotations of the input terminals 4 and 5 and the output terminals 6 to 8 when external wirings are mounted thereto. In states where the input terminals 4 and 5 and the output terminals 6 to 8 have been placed on the terminal mounting areas 121c, upper ends of the sandwiching walls 121a are positioned between lower ends of the sealing mounting portions 35 and 43 in the external wiring connection portions 30 and 40, and upper ends of the substrate-fixed portions 31 and 41.

The securing portions 122 secure the secure bracket 21 to the upper substrate 13. The securing portions 122 are provided in the secure bracket 21 at its one side end portion and its other side end portion. Each securing portion 122 is provided with a penetration hole for penetrating a securing screw 26 therethrough. The securing screws 26 inserted through the penetration holes in the securing portions 122 are fastened, through a screw effect, to screw holes formed in the heat sink 10, with the upper substrate 13, the relay electrodes 19 and the lower substrate 11 interposed therebetween. Thus, the secure bracket 21 is secured to the lower substrate 11. The positions at which the securing portions 122 are mounted therein are utilized as the positions at which the relay electrodes 19 are secured thereto, so that the secure bracket 21 is secured to the upper substrate 13 without increasing the size of the inverter device.

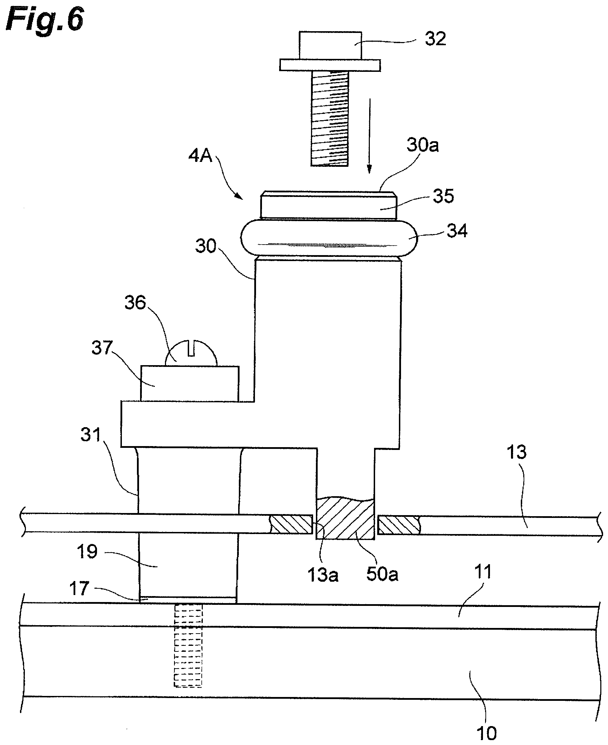

Hereinafter, with reference to Figs. 6 and 7, effects of the present embodiment will be described. Fig. 6 is a side view illustrating a structure for securing a conventional terminal electrode, as a comparative example. Fig. 7 is a side view illustrating a structure for securing a terminal electrode according to the present embodiment.

At first, with reference to Fig. 6, there will be described a method for securing a conventional terminal electrode to a substrate. As illustrated in Fig. 6, an inverter device 1 may employ a structure for securing a terminal electrode 4A such as an input terminal 4 to a substrate, at a single point, for example.

As described above, when an external terminal (not illustrated) is connected to an external wiring connection portion 30 in the terminal electrode 4A, the external wiring connection portion 30 may be rotated about a substrate-fixed portion 31, in some cases. In order to prevent displacements and rotations of the external wiring connection portion 30, utilization of the following structure may be possibly contrived. The external wiring connection portion 30 in the terminal electrode 4A is provided with a protruding portion 50a, at a lower portion thereof. A positioning hole 13a for positioning the protruding portion 50a is formed in the upper substrate 13. The protruding portion 50a and the positioning hole 13a are engaged with each other, which prevents displacements and rotations of the external wiring connection portion 30.

With the structure illustrated in Fig. 6, the upper substrate 13 is provided with the positioning hole 13a at a portion thereof. In cases where the circuit substrate is provided with a penetration hole such as a positioning hole, no other electronic component can be mounted thereon at the position of this hole. Further, no electronic component can be mounted thereon within a predetermined range from the portion where the positioning hole is formed, due to constraints on the circuit structure. This makes it impossible to effectively utilize the upper substrate 13. Therefore, in order to mount other electronic components thereon, it is necessary to increase the size of the substrate, which may obstruct reduction in size of the device. Further, the positioning hole 13a should be formed in the upper substrate 13 near the connection portion of the terminal electrode 4A, which causes a thermal disadvantage to the upper substrate 13.

On the contrary, as illustrated in Fig. 7, in the present embodiment, the input terminal 4 is secured to the upper substrate 13 through the secure bracket 21. In this case, when the substrate-fixed portion 31 of the input terminal 4 has been inserted into the penetration hole 121b, the substrate-fixed portion 31 and the external wiring connection portion 30 are held at their side surfaces by the pair of the sandwiching walls 121a in the holding portion 121. Therefore, even if a force is exerted on the input terminal 4 in such a direction as to rotate the external wiring connection portion 30 about the substrate-fixed portion 31, the pair of the sandwiching walls 121a inhibits the external wiring connection portion 30 from being rotated. Namely, the holding portions 121 having the respective pairs of the sandwiching walls 121a function as a rotation suppressing portion for suppressing the rotations of the terminals 4 to 8. This eliminates the necessity of forming the positioning hole 13a in the upper substrate 13. Accordingly, there is no need for increasing the size of the upper substrate 13, which enables reduction in size of the inverter device 1. Further, the terminal securing screw 36 is fastened, through a screw function, to a screw hole formed in the heat sink 10, with the upper substrate 13, the relay electrode 19 and the lower substrate 11 interposed therebetween, so that these members are secured integrally. Thus, even in cases where the input terminal 4 is connected and secured to the lower substrate 11, it is not necessary to form a hole in the upper substrate 13, which causes less thermal disadvantages to the inverter device 1.

In the present embodiment, the input terminals 4 and 5 and the output terminals 6 to 8 are mounted on the upper substrate 13 (the lower substrate 11), and the secure bracket 21 includes the holding portions 121 such that the number of the holding portions 121 corresponds to the number of the terminals 4 to 8, and the plurality of holding portions 121 are formed integrally. In this case, the secure bracket 21 holds the input terminals 4 and 5 and the output terminals 6 to 8, at the same time. This reduces the number of members in the secure bracket 21 to be used therein.

In the present embodiment, at least one sandwiching wall 121a, out of the pair of sandwiching walls 121a included in at least one holding portion 121, is configured to form one sandwiching wall 121a, out of the pair of sandwiching walls 121a included in the holding portion 121 placed adjacent thereto. This can realize the structure having the input terminals 4 and 5 and the output terminals 6 to 8 which are secured to the lower substrate 11 in the state where they are arranged substantially in a line.

In the present embodiment, the pairs of the sandwiching walls 121a are configured to sandwich the terminals at their opposite side walls from the upper portions of the substrate-fixed portions 31 and 41 up to the lower portions of the external wiring connection portions 30 and 40. Namely, the terminals 4 to 8 are sandwiched thereby at their side surfaces up to the lower portions of the external wiring connection portions 30 and 40. Therefore, for example, when the external wirings are mounted thereto, even if rotational moments are exerted on the terminals 4 to 8, it is possible to certainly suppress rotations of the terminals 4 to 8.

In the present embodiment, the secure bracket 21 includes the terminal mounting areas 121c for supporting the lower portions of the external wiring connection portions 30 and 40. This enables holding the terminals 4 to 8 more stably.

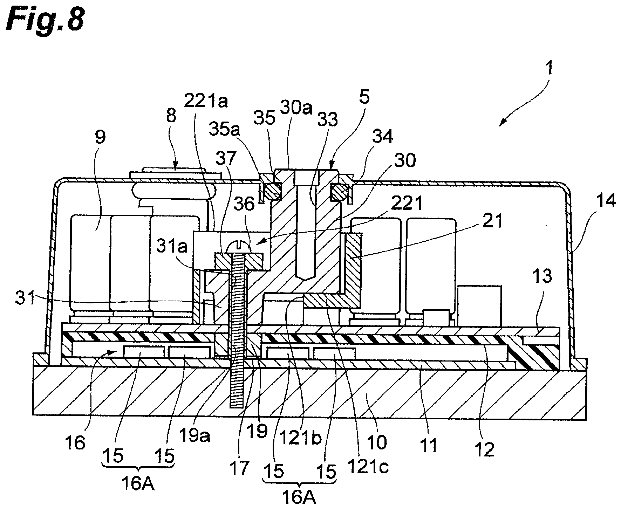

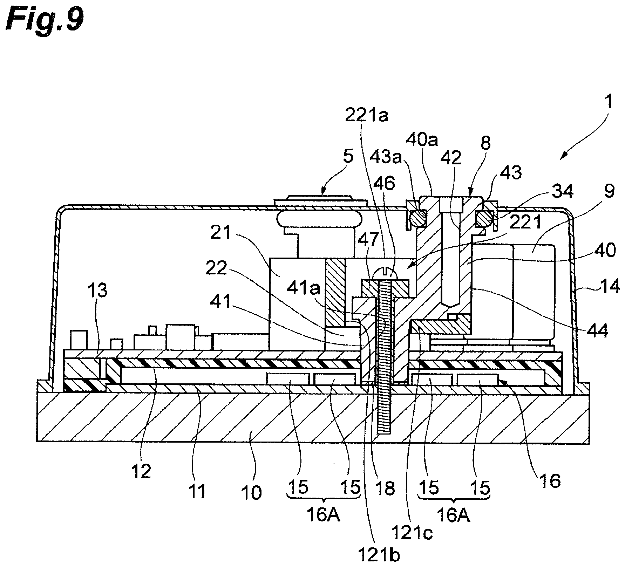

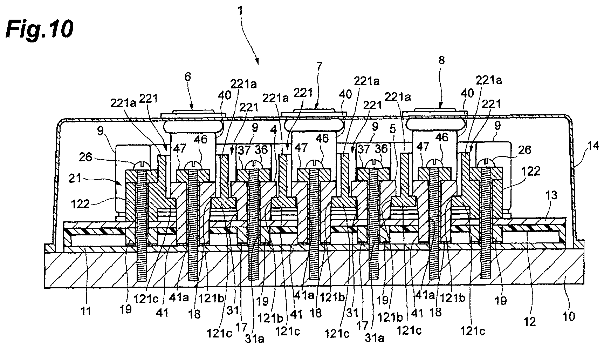

Next, with reference to Figs. 8 to 10, there will be described the structure of an inverter device in a modification example of the present embodiment. Figs. 8 to 10 are sectional views of the inverter device in the present modification example. Fig. 8 illustrates a sectional structure which corresponds to the sectional structure of the inverter device in the present modification example taken along the position coincident with the IIA-IIA line in Fig. 4. Fig. 9 illustrates a sectional structure which corresponds to the sectional structure of the inverter device in the present modification example taken along the position coincident with the IIB-IIB line in Fig. 4. Fig. 10 illustrates a sectional structure which corresponds to the sectional structure of the inverter device in the present modification example taken along a plane orthogonal to the IIA-IIA line and the line IIB-IIB in Fig. 4.

The inverter device in the present modification example includes a lower substrate 11, an upper substrate 13, a case 14, a plurality of input terminals 4 and 5, a plurality of output terminals 6 to 8, and a secure bracket 21, similarly to the inverter device 1 according to the aforementioned embodiment. In the present modification example, the relationship between the sizes of the plurality of input terminals 4 and 5 and the plurality of output terminals 6 to 8, and the size of the secure bracket 21 is different from that in the aforementioned embodiment.

The secure bracket 21 includes a plurality of terminal placement portions (in this case, five terminal placement portions) 221, and a plurality of securing portions (in this case, two securing portions) 122. The secure bracket 21 is a member constituted by these terminal placement portions 221 and these securing portions 122 which are integrally formed and, further, the secure bracket 21 is made of a resin. The input terminals 4 and 5 and the output terminals 6 to 8 are placed in the respective corresponding terminal placement portions 221. Namely, the secure bracket 21 functions as a terminal electrode placement member for placing the input terminals 4 and 5 and the output terminals 6 to 8 therein. The number of the terminal placement portions 221 is equal to the number of the terminals 4 to 8.

Each terminal placement portion 221 includes a terminal mounting area 121c for mounting, thereon, the corresponding one of substrate-fixed portions 31 of the input terminals 4 and 5 and substrate-fixed portions 41 of the output terminals 6 to 8, similarly to the holding portions 121 according to the aforementioned embodiment. The terminal mounting area 121c in each terminal placement portion 221 is provided with a penetration hole 121b. Each terminal placement portion 221 has a pair of walls 221a opposing each other. The pair of walls 221a are positioned in the opposite sides beside the terminal 4 to 8 which is inserted into the penetration hole 121b formed in the terminal placement portion 221, at its substrate-fixed portion 31 or 41. The respective terminal placement portions 221 are arranged in substantially the same direction as a direction in which the pairs of the walls 221a are opposed to each other. Each wall 221a extends in a direction orthogonal to the lower substrate 11.

The plurality of terminal placement portions 221 are in different locations along in a direction orthogonal to the direction in which the pairs of the walls 221a are opposed to each other. Therefore, through the secure bracket 21, the input terminals 4 and 5 are placed on the upper substrate 13, near an area in which the components of the control circuit 3 are mounted thereon. Through the secure bracket 21, the output terminals 6 to 8 are placed on the upper substrate 13, near an area in which the capacitors 9 are mounted thereon.

The intervals between the pairs of the walls 221a in the direction in which the pairs of the walls 221a are opposed to each other are larger than the widths of the respective terminals 4 to 8 in the direction in which the pairs of the walls 221a are opposed to each other. Namely, in the state where the respective terminals 4 to 8 are placed in the corresponding terminal placement portions 221, there is formed a clearance between each terminal 4 to 8 and at least one wall 221a out of the corresponding pair of walls 221a.

Each two terminal placement portions 221 adjacent to each other share the wall positioned between these two terminal placement portions 221, out of the corresponding pair of walls 221a. Namely, one terminal placement portion 221, out of two terminal placement portions 221 adjacent to each other, includes a wall 221a which also function as a wall 221a in the other terminal placement portion 221. In other words, at least one wall 221a, out of the pair of walls 221a included in a certain terminal placement portion 221 also functions as at least one wall 221a, out of the pair of walls 221a included in the terminal placement portion 221 placed adjacent to the aforementioned certain terminal placement portion 221.

The walls 221a are opposed to the opposite side surfaces of the input terminals 4 and 5 and the output terminals 6 to 8, from upper portions of the substrate-fixed portions 31 and 41 up to lower portions of the external wiring connection portions 30 and 40. In other words, the walls 221a are opposed to the input terminals 4 and 5 and the output terminals 6 to 8, from end portions of the substrate-fixed portions 31 and 41 which are farther from the lower substrate 11 up to end portions of the external wiring connection portions 30 and 40 which are closer to the lower substrate 11. In states where the input terminals 4 and 5 and the output terminals 6 to 8 have been placed on the terminal mounting areas 121c, upper ends of the walls 221a are positioned between lower ends of the sealing mounting portions 35 and 43 in the external wiring connection portions 30 and 40, and upper ends of the substrate-fixed portions 31 and 41.

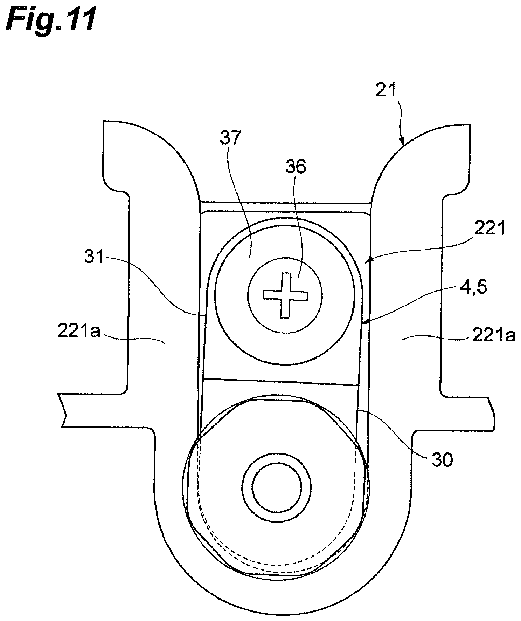

The input terminals 4 and 5 are secured to the upper substrate 13 (the lower substrate 11), through the terminal securing screws 36, as described above. When the terminal securing screws 36 are fastened to screw holes formed in the heat sink 10, along with the rotations of the terminal securing screws 36, the input terminals 4 and 5 may be rotated in the same direction as a direction of the rotations of the terminal securing screws 36, such that the terminal securing screws 36 serve as approximate rotational centers. At this time, the input terminals 4 and 5 come into contact with the walls 221a which are positioned in the front side in the direction of the rotations of the input terminals 4 and 5, which inhibits the input terminals 4 and 5 from being rotated (see Fig. 11). Accordingly, in the state where the terminal securing screws 36 have been fastened to the heat sink 10, the input terminals 4 and 5 may be in contact with the walls 221a, in some cases.

The output terminals 6 to 8 are secured to the lower substrate 11, through the terminal securing screws 46, as described above. When the terminal securing screws 46 are fastened to screw holes formed in the heat sink 10, along with the rotations of the terminal securing screws 46, the output terminals 6 to 8 may be rotated in the same direction as a direction of the rotations of the terminal securing screws 46, such that the terminal securing screws 46 serve as approximate rotational centers. At this time, the output terminals 6 to 8 come into contact with the walls 221a which are positioned in the front side in the direction of the rotations of the output terminals 6 to 8, similarly to the input terminals 4 and 5, which inhibits the output terminals 6 to 8 from being rotated. Accordingly, in the state where the terminal securing screws 46 have been fastened to the heat sink 10, the output terminals 6 to 8 may be in contact with the walls 221a, in some cases.

As described above, when bolts are fastened to the external wiring connection portions 30 and 40 for securing external terminals to the external wiring connection portions 30 and 40, the input terminals 4 and 5 and the output terminals 6 to 8 may be rotated, in some cases. In this case, similarly, the input terminals 4 and 5 and the output terminals 6 to 8 come into contact with the walls 221a which are positioned in the front side in the direction of the rotations of the input terminals 4 and 5, which inhibits the input terminals 4 and 5 from being rotated.

As described above, in the present modification example, the walls 221a in the terminal placement portions 221 are such that the terminals 4 to 8 come into contact with these walls 221a, which inhibit the terminals 4 to 8 from being rotated. Namely, the terminal placement portions 221 having the walls 221a function as a rotation suppressing portion for suppressing rotations of the terminals 4 to 8. The terminal placement portions 221 (the walls 221a) inhibit the input terminals 4 and 5 and the output terminals 6 to 8 from being rotated. Therefore, the input terminals 4 and 5 and the output terminals 6 to 8 are not required to include an additional rotation preventing mechanism. This prevents the structures of the input terminals 4 and 5 and the output terminals 6 to 8 from being complicated. Further, it is possible to increase the density of electronic components mounted on the substrate, which enables reduction in size of the semiconductor device, similarly to in the aforementioned embodiment.

The intervals between the pairs of the walls 221a in the direction in which the pairs of the walls 221a are opposed to each other are larger than the widths of the respective terminals 4 to 8 in the direction in which the pairs of the walls 221a are opposed to each other. This enables easily inserting the substrate-fixed portions 31 and 41 of the input terminals 4 and 5 and the output terminals 6 to 8, through the penetration holes 121b. This makes it easier to place the respective terminals 4 to 8 in the secure bracket 21. The input terminals 4 and 5 and the output terminals 6 to 8 are positioned in the secure bracket 21, through the corresponding pairs of walls 221a.

In the present modification example, the secure bracket 21 includes the terminal mounting areas 121c for supporting the lower portions of the external wiring connection portions 30 and 40. This enables holding the terminals 4 to 8 more stably.

In the present modification example, the secure bracket 21 includes the plurality of terminal placement portions 221, and the plurality of terminal placement portions 221 are formed integrally. Since the input terminals 4 and 5 and the output terminals 6 to 8 are placed in the secure bracket 21, it is possible to reduce the number of members in the secure bracket 21 to be used.

In the present modification example, each two terminal placement portions 221 adjacent to each other share the wall 221a positioned between these two terminal placement portions 221, out of the corresponding pair of walls 221a. This can realize the structure having the input terminals 4 and 5 and the output terminals 6 to 8 which are placed on the upper substrate 13 (the lower substrate 11), in the state where they are arranged substantially in a line, for example.

Further, the present invention is not limited to the aforementioned embodiment and the aforementioned modification example. For example, although, in the aforementioned embodiment,, there has been described a case where the input terminal 4 is secured through the secure bracket 21, with reference to Fig. 7, the present invention is not limited thereto, and it is also possible to secure the input terminal 5 or the output terminals 6 to 8 through the secure bracket 21, which can offer the aforementioned effects and advantages, similarly.

The present invention is not limited to three-phase inverter devices 1 as in the present embodiment and in the modification example and can also be applied to DC-DC converters, for example.

From the invention thus described, it will be obvious that the invention may be varied in many ways. Such variations are not to be regarded as a departure from the scope of the invention as defined by the claims.

## Claims

1. An inverter device comprising:
a terminal electrode (4) connected to a circuit substrate (11) having a plurality of semiconductor elements mounted thereon; and
a terminal electrode placement member (21) configured to place the terminal electrode (4) therein, and
a capacitor substrate (13) having a plurality of capacitors (9) mounted thereon, the capacitor substrate (13) being placed oppositely to the circuit substrate (11),
wherein
the terminal electrode (4) includes a substrate-fixed portion (31) secured to the circuit substrate (11) through a fastening member (36), and an external wiring connection portion (30) to which an external wiring is connected, the substrate-fixed portion (31) and the external wiring connection portion (30) being eccentrically located when viewed from a direction orthogonal to the circuit substrate (11),
the terminal electrode placement member (21) is placed on a surface of the capacitor substrate (13) which is opposite from a surface of the capacitor substrate (13) which is opposite to the circuit substrate (11) and includes a plurality of securing portions (122) which are secured to the circuit substrate (11), and a rotation suppressing portion (121) configured to suppress a rotation of the terminal electrode (4), and the rotation suppressing portion (121) is provided with a penetration hole (121b) for penetrating the substrate-fixed portion (31) therethrough, and
the rotation suppressing portion (121) includes a pair of walls (121a) which are opposed to each other and also are positioned in opposite sides beside the terminal electrode (4) which is inserted into the penetration hole (121b) at the substrate-fixed portion (31), the terminal electrode (4) coming into contact with these walls (121a) for suppressing the rotation of the terminal electrode (4).

2. The inverter device according to Claim 1, wherein
the pair of the walls (121a) are configured to sandwich the terminal electrode.

3. The inverter device according to Claim 2, wherein
the substrate-fixed portion (31) is positioned closer to the circuit substrate (11) than the external wiring connection portion (30), and
the pair of the walls (121a) sandwich the terminal electrode (4), from an end portion of the substrate-fixed portion (31) which is farther from the circuit substrate (11), up to an end portion of the external wiring connection portion (30) which is closer to the circuit substrate (11).

4. The inverter device according to Claim 1, wherein
an interval between the pair of the walls (121a) in a direction in which the pair of the wall (121a) are opposed to each other is larger than a width of the terminal electrode (4) in the direction in which the pair of the walls (121a) are opposed to each other.

5. The inverter device according to any one of Claims 1 to 4, wherein a plurality of said terminal electrodes (4) are connected to the circuit substrate (11),
the terminal electrode placement member (21) includes a plurality of said rotation suppressing portions (121), and
the plurality of the rotation suppressing portions (121) are formed integrally.

6. The inverter device according to Claim 5, wherein two rotation suppressing portions (121) adjacent to each other, out of the plurality of the rotation suppressing portions (121), are configured to share a wall positioned between these two rotation suppressing portions (121), out of the pair of walls (121a).

7. The inverter device according to any one of Claims 1 to 6, wherein the terminal electrode placement member (21) has a supporting portion (121c) configured to support the external wiring connection portion (30).

## Patentansprüche

1. Wechselrichtervorrichtung mit:
einer Anschlusselektrode (4), die mit einem Schaltungssubstrat (11) mit einer Vielzahl an darauf montierten Halbleiterelementen verbunden ist; und
ein Anschlusselektroden-Platzierungselement (21), das konfiguriert ist um die Anschlusselektrode (4) darin zu platzieren, und
einem Kondensatorsubstrat (13) mit einer Vielzahl an darauf montierten Kondensatoren, wobei das Kondensatorsubstrat (13) gegenüber dem Schaltungssubstrat (11) angeordnet ist,
wobei
die Anschlusselektrode (4) einen substratfixierten Abschnitt (31), der über ein Befestigungselement (36) an dem Schaltungssubstrat (11) befestigt ist, und einen externen Verdrahtungsverbindungsabschnitt (30) umfasst, mit dem eine externe Verdrahtung verbunden ist, wobei der substratfixierte Abschnitt (31) und der externe Verdrahtungsverbindungsabschnitt (30) bei Betrachtung aus einer Richtung orthogonal zu dem Schaltungssubstrat (11) exzentrisch angeordnet sind,
das Anschlusselektroden-Platzierungselement (21) auf einer Fläche des Kondensatorsubstrats (13) angeordnet ist, die einer Fläche des Kondensatorsubstrats (13) gegenüberliegt, die dem Schaltungssubstrat (11) gegenüberliegt und eine Vielzahl von Befestigungsabschnitten (122) umfasst, die an dem Schaltungssubstrat (11) befestigt sind, und ein Rotationsunterdrückungsabschnitt (121) konfiguriert ist, um eine Drehung der Anschlusselektrode (4) zu unterdrücken, und der Rotationsunterdrückungsabschnitt (121) mit einem Durchgangsloch (121b) zum Durchdringen des substratfixierten Abschnitt (31) durch diesen versehen ist, und
der Rotationsunterdrückungsabschnitt (121) ein Paar von Wänden (121a) umfasst, die einander gegenüberliegen und auch auf gegenüberliegenden Seiten neben der Anschlusselektrode (4) angeordnet sind, die in das Durchgangsloch (121b) an dem substratfixierten Abschnitt (31) eingesetzt ist, wobei die Anschlusselektrode (4) mit diesen Wänden (121a) in Kontakt kommt, um die Drehung der Anschlusselektrode (4) zu unterdrücken.

2. Wechselrichtervorrichtung nach Anspruch 1, wobei
das Paar der Wände (121a) konfiguriert ist, um die Anschlusselektrode (4) einzukeilen.

3. Wechselrichtervorrichtung nach Anspruch 2, wobei
der substratfixierte Abschnitt (31) näher an dem Schaltungssubstrat (11) positioniert ist als der externe Verdrahtungsverbindungsabschnitt (30), und
das Paar der Wände (121a) die Anschlusselektrode (4) von einem Endabschnitt des substratfixierten Abschnitts (31), der weiter von dem Schaltungssubstrat (11) entfernt ist, bis zu einem Endabschnitt des externen
Verdrahtungsverbindungsabschnitts (30), der näher an dem Schaltungssubstrat (11) liegt, einkeilt.

4. Wechselrichtervorrichtung nach Anspruch 1, wobei
ein Abstand zwischen dem Paar der Wände (121a) in einer Richtung, in der das Paar der Wände (121a) einander gegenüberliegt, größer ist als eine Breite der Anschlusselektrode (4) in einer Richtung, in der sich das Paar der Wände (121a) einander gegenüberliegt.

5. Wechselrichtervorrichtung nach einem der Ansprüche 1 bis 4, wobei
eine Vielzahl der besagten Anschlusselektroden (4) mit dem Schaltungssubstrat (11) verbunden ist,
das Anschlusselektroden-Platzierungselement (21) eine Vielzahl der besagten Rotationsunterdrückungsabschnitte (121) umfasst, und
die Vielzahl der Rotationsunterdrückungsabschnitt (121) integral ausgebildet sind.

6. Wechselrichtervorrichtung nach Anspruch 5, wobei
zwei Rotationsunterdrückungsabschnitte (121), die aus der Vielzahl der Rotationsunterdrückungsabschnitte (121) aneinander angrenzen, konfiguriert sind, um sich eine Wand aus dem Paar von Wänden (121a) zu teilen, die zwischen diesen beiden Rotationsunterdrückungsabschnitten (121) angeordnet ist.

7. Wechselrichtervorrichtung nach einem der Ansprüche 1 bis 6, wobei
das Anschlusselektroden-Platzierungselement (21) einen Stützabschnitt (121c) umfasst, der konfiguriert ist, um den externen Verdrahtungsverbindungsabschnitt (30) zu tragen.

## Revendications

1. Dispositif onduleur comprenant :
une électrode de borne (4) reliée à un substrat de circuit (11) ayant une pluralité d'éléments semiconducteurs montés sur celui-ci ; et
un élément de placement d'électrode de borne (21) configuré pour placer l'électrode de borne (4) à l'intérieur de celui-ci ; et
un substrat de condensateur (13) ayant une pluralité de condensateurs (9) montés sur celui-ci, le substrat de condensateur (13) étant placé à l'opposé du substrat de circuit (11),
dans lequel
l'électrode de borne (4) comprend une partie fixe de substrat (31) fixée au substrat de circuit (11) à travers un élément de fixation (36) et une partie de connexion de câblage externe (30) à laquelle est relié un câblage externe, la partie fixe de substrat (31) et la partie de connexion de câblage externe (30) étant situées de manière excentrique lorsqu'elles sont vues d'une direction perpendiculaire au substrat de circuit (11),
l'élément de placement d'électrode de borne (21) est placé sur une surface du substrat de condensateur (13) qui est à l'opposé d'une surface du substrat de condensateur (13) qui est opposée au substrat de circuit (11) et comprend une pluralité de parties de fixation (122) qui sont fixées au substrat de circuit (11), et une partie de suppression de rotation (121) configurée pour supprimer une rotation de l'électrode de borne (4), et la partie de suppression de rotation (121) est pourvue d'un trou de pénétration (121b) pour faire pénétrer à travers celui-ci la partie fixe de substrat (31), et
la partie de suppression de rotation (121) comprend une paire de parois (121a) qui sont opposées l'une à l'autre et qui sont également positionnées à des côtés opposés à côté de l'électrode de borne (4) qui est insérée à l'intérieur du trou de pénétration (121b) à la partie fixe de substrat (31), l'électrode de borne (4) venant en contact avec ces parois (121a) pour supprimer la rotation de l'électrode de borne (4).

2. Dispositif onduleur selon la revendication 1, dans lequel
la paire de parois (121a) sont configurées de façon à prendre en sandwich l'électrode de borne.

3. Dispositif onduleur selon la revendication 2, dans lequel
la partie fixe de substrat (31) est positionnée plus à proximité du substrat de circuit (11) que la partie de connexion de câblage externe (30), et
la paire de parois (121a) prend en sandwich l'électrode de borne (4) à partir d'une partie d'extrémité de la partie fixe de substrat (31) qui est plus éloignée du substrat de circuit (11), jusqu'à une partie d'extrémité de la partie de connexion de câblage externe (30) qui est plus à proximité du substrat de circuit (11).

4. Dispositif onduleur selon la revendication 1, dans lequel
un intervalle entre la paire de parois (121a) dans une direction dans laquelle la paire de parois (121a) sont opposées l'une à l'autre est plus grand qu'une largeur de l'électrode de borne (4) dans la direction dans laquelle la paire de parois (121a) sont opposées l'une à l'autre.

5. Dispositif onduleur selon l'une quelconque des revendications 1 à 4, dans lequel
une pluralité desdites électrodes de borne (4) est reliée au substrat de circuit (11),
l'élément de placement d'électrode de borne (21) comprend une pluralité desdites parties de suppression de rotation (121), et
la pluralité des parties de suppression de rotation (121) sont formées d'un seul tenant.

6. Dispositif onduleur selon la revendication 5, dans lequel
deux parties de suppression de rotation (121) adjacentes l'une à l'autre, de la pluralité de parties de suppression de rotation (121), sont configurées pour partager une paroi positionnée entre ces deux parties de suppression de rotation (121), de la paire de parois (121a).

7. Dispositif onduleur selon l'une quelconque des revendications 1 à 6, dans lequel
l'élément de placement d'électrode de borne (21) a une partie de support (121c) configurée pour supporter la partie de connexion de câblage externe (30).
